Europäisches Patentamt

European Patent Office

Office européen des brevets

(19)

(11) Numéro de publication: **0 104 686**

**B1**

(12) **FASCICULE DE BREVET EUROPÉEN**

(45) Date de publication du fascicule du brevet: 24.09.86

(21) Numéro de dépôt: **83201243.9**

(22) Date de dépôt: **31.08.83**

(51) Int. Cl.⁴: **H 01 L 21/28,** H 01 L 21/308, G 03 F 7/02

(54) Procédé de réalisation d'ouverture de faible dimension, utilisation de ce procédé pour la fabrication de transistors à effet de champ, à grille alignée submicronique, et transistors ainsi obtenus.

(30) Priorité: **01.09.82 FR 8214944**

(43) Date de publication de la demande: **04.04.84 Bulletin 84/14**

(45) Mention de la délivrance du brevet: **24.09.86 Bulletin 86/39**

(84) Etats contractants désignés: **DE FR GB IT NL**

(56) Documents cité:
EP-A-0 054 998
US-A-4 256 816

**IBM TECHNICAL DISCLOSURE BULLETIN, vol. 21, no. 4, septembre 1978, New York (US) R.M. GEFFKEN et al.: "Self-aligned double lift-off process", pages 1367-1368**

(73) Titulaire: **Laboratoires d'Electronique et de Physique Appliquée L.E.P., 3, Avenue Descartes, F-94450 Limeil- Brévannes (FR)**

(84) Etats contractants désignés: **FR**

(73) Titulaire: **N.V. Philips' Gloeilampenfabrieken, Groenewoudseweg 1, NL- 5621 BA Eindhoven (NL)**

(84) Etats contractants désignés: **DE GB IT NL**

(72) Inventeur: **Meignant, Didier Serge, Société Civile S.P.I.D. 209 rue de l'Université, F-75007 Paris (FR)**

(74) Mandataire: **Landousy, Christian, Société Civile S.P.I.D. 209, Rue de l'Université, F-75007 Paris (FR)**

## Description

L'invention concerne un procédé de réalisation d'ouverture de faible dimension et l'utilisation de ce procédé pour la fabrication de transistors à effet de champ, à grille alignée submicronique, ainsi que les transistors obtenus par la mise en oeuvre de ce proédé. D'une manière générale, l'invention ressort du domaine de l'électronique, plus spécifiquement de la technologie de fabrication des composants semiconducteurs.

De tels procédés de fabrication sont connus de l'art antérieur, et l'on citera pour exemple la demande de brevet EP-A-005 4998 revendiquant une priorié du 24 Décembre 1980 au nom de la demanderesse et décrivant également un procédé de fabrication de transistors FET à grille submicronique et drain Schottky sans masque submicronique, par sous-gravure sur un seul bord médian, et alignement.

Ce procédé a notamment permis de réaliser des transistors FE à grille submicronique, sans masque submicronique, à partir d'une utilisation astucieuse d'une technique usuelle telle que la photogravure, et comportait les étapes suivantes:

a) dépôt, sur un matériau semiconducteur, d'une première couche métallique, en un métal formant un contact redresseur avec le matériau semiconducteur;

b) dépôt sur ladite première couche métallique d'une laque photosensible;

c) exposition de ladite laque à un rayonnement sensibilisant, à travers un masque qui découvre une zone entière, définissant l'électrode de drain;

d) dissolution de la laque non sensibilisée, avec un solution appropriée;

e) sous-gravure, de ladite première couche métallique sur une distance typiquement inférieure au micromètre;

f) dépôt d'une deuxième couche métallique, alignée sur le bord de la laque précédemment sous-gravée, en un métal ou alliage métallique, formant un contact ohmique avec le matériau semiconducteur, de manière à réaliser l'électrode de source;

g) enlèvement de la laque sensibilisée, avec une solution approrpriée;

h) gravure de matériau semiconducteur, dans la zone non recouverte délimitée par les première et deuxième couches métalliques, sous la forme d'une cavité;

i) dépôt d'une troisième couche métallique, dans ladite cavité, en un métal formant un contact redresseur avec le matériau semiconducteur, de manière à réaliser l'électrode de grille, par auto-alignement sur les bords supérieurs de ladite cavité.

Mais, les transistors FET obtenus par la mise en oeuvre du procédé décrit dans ladite demande sont des transistors très paticuliers à drain Schottky, et le procédé ne pouvait pas s'appliquer pour la fabrication des transistors les plus généraux.

L'invention vise donc à décrire un procédé plus général de réalisation d'ouverture de faible dimension permettant d'obtenir dans une utilisation paticulière toutes sortes de transistors à effet de champ, notamment le transistor ET classique, à électrodes de drain et de source sous la forme de contacts ohmiques et à grille Schottky.

Le procédé selon la présente invention est remarquable en ce qu'il consiste én les étapes suivantes:

a) dépôt sur le substrat d'une couche de la que sensible à des rayonnements de faible longueur d'onde, d'une couche de matériau opaque à ces rayonnements, et d'une seconde couche de laque sensible à des rayonnements de plus forte longueur d'onde;

b) exposition au rayonnement de plus forte longueur d'onde à travers un masque qui découvre une zone entière du substrat ainsi recouvert;

c) dissolution de la portion de ladite seconde couche de laque illuminée;

d) attaque de la couche de matériau opaque non recouverte de laque, et poursuite jusqu'à l'obtention d'une sous-gravure sur une distance typiquement inférieure au micromètre.

e) dépôt d'une nouvelle couche de matériau opaque, par alignement sur le bord découvert de ladite seconde couche de laque;

f) dissolution de la seconde couche de laque non illuminée;

g) exposition au rayonnement de faible longueur d'onde;

h) dissolution de la première couche de laque illuminée;

i) gravure du substrat, sous la forme d'une ouverture de faible dimension;

j) dissolution de la première couche de laque non illuminée.

De cette manière, on obtient une ouverture présentant ne dimension submicronique, sans masque submicronique, par alignement sur un motif intermédiaire qui disparaît après usage.

La description qui va suivre en regard des dessins annexés, donnés à titre non limitatif, permettra de mieux comprendre comment l'invention s'exécute et se poursuit et de mieux en déterminer sa portée.

Les figures i à 8 représentent les diverses étapes du procédé selon la présente invention, appliqué à la réalisation de transistors FET.

Les procédés de fabrication des transistors FET par auto-alignement sont bien connus de l'art antérieur et décrits par exemple dans le brevet français n- 1.437.781 au nom de la Société dite N.V. PHILIPS' GLOEILAMPENFABRIEKEN, dans une variante dite additive, et dans le brevet des Etats-Unis d'Amérique n° 3,678,573 au nom de la Société dite WESTINGHOUSE ELECTRIC Corp., dans une variante dite soustractive.

Mais, ces procédés de photogravure aux travers de masques présentent une limitation inhérente au moyen utilisé, dans les phénomènes de diffraction des rayonnements utilisés, qui sont généralement des ultra-violets pour impressionner les systèmes de laques employés et qui impose l'utilisation d'ouvertures supérieures au micromètre.

La demande de brevet précitée EP-A-0 054 998 a permis de réaliser des ouvertures inférieures au micron, par exemple de l'ordre de 0,5 μm, par une utilisation astucieuse des techniques de photogravure et de sous-gravure, mais le procédé ainsi décrit ne trouvait application que pour des transistors particuliers, à drain Schottky.

Il est également connu de l'art antérieur, notamment de la revue IBM Technical Disclosure Bulletin, Vol. 19, n°11, Avril 1977, pages 4089-4090, un procédé de fabrication d'espaces submicroniques, par sous-gravure simultanée des deux bords d'une fenêtre micronique et dépôt d'une couche protectrice par alignement sur les deux bords, qui laisse découvertes deux zones latérales sur une distance qui peut être inférieure au micromètre.

Le procédé selon la présente invention diffère de ce dernier par les moyens utilisés -pas de sous-gravure des deux bords d'une fenêtre, ni dépôt de couche protectrice-, et par le résultat obtenu -un seul espace submicronique-, ainsi que le prouve la description suivante des figures, illustration du procédé dans une application particulière.

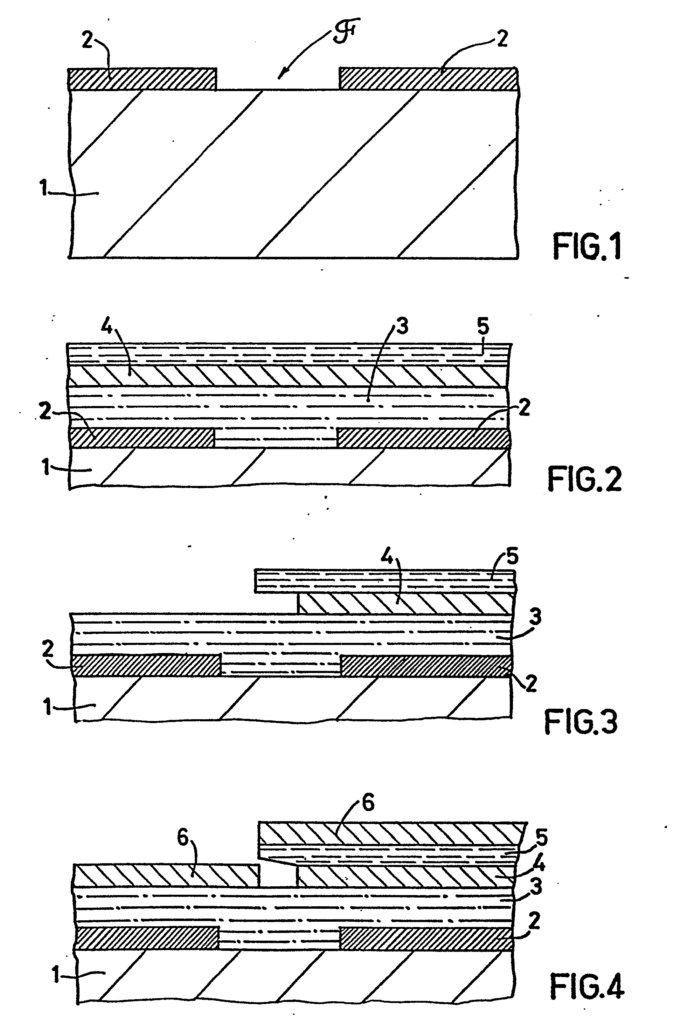

Le matériau semiconducteur 1, tel que référencé à la figure 1, est par exemple de l'arséniure de gallium GaAs, sur lequel est déposée une première couche métallique 2, en un métal ou alliage formant contact ohmique, par exemple un alliage or-germanium (Au-Ge = 80/20) déposé par exemple par évaporation. Cette évaporation peut s'effectuer sur l'entière surface du semiconducteur quitte à retirer ultérieurement de la matière par les techniques habituelles de photogravure, de façon à ouvrir une première fenêtre micronique F, ou bien uniquement sur des zones délimitées de manière à réaliser les electrodes de source et de drain, des caches protégeant les autres parties de la surface, cette deuxième variante êtant à ce jour plus générâlement utilisée.

On dépose ensuite une seconde couche 3 en une laque sensible aux rayonnements de faible longueur d'onde, comme les ultraviolets profonds ou les rayons X, par exemple en PMMA, telle que représentée à la figure 2, puis une troisième couche 4, en un matériau opaque à ces rayonnements tel que de la silice SiO$_2$, ou du nitrure de silicium Si$_3$N$_4$, ou même divers métaux tels que l'aluminium Al, le tantale Ta, ou l'or Au..., par exemple par evaporation et enfin une quatrième couche 5, en une laque sensible aux rayonnements ultraviolets, par exemple la laque commercialisée par la firme Shipley, sous la référence AZ 1350, d'une faible épaisseur, de l'ordre de 500 μ (5000 Angstroems).

On expose alors le substrat ainsi recouvert à un rayonnement sensibilisant, par exemple à des rayonnements ultraviolets, à travers un masque qui découvre en son milieu ledit transistor à effet de champ, selon la ligne médiane principale de la première fenêtre micronique F, tel que représente à la figure 3, et l'on enlève la laque sensibilisée au moyen d'un dissolvant commun tel qu'une solution basique diluée (par exemple une solution de soude diluée) et la couche opaque 4, par exemple de silice SiO$_2$ ou de tantale Ta est alors gravée, par exemple au moyen d'un plasma CF$_4$/O$_2$ et sous-gravée sur une distance typiquement inférieure au micromètre par exemple de l'ordre de 0,5 μm, sous la portion de couche de laque restante 5, d'une manière parfaitement nette et contrôlée, par exemple sur cette distance de 0,5 μm en un temps de l'ordre de quelques minutes. La bordure est parfaitement régulière avec des irrégularités qui n'excèdent pas 10 μ (100 Angstroems).

On dépose alors une nouvelle couche 6 en le même matériau que celui de la troisième couche, par exemple de la silice SiO$_2$, en profitant de l'effet d'ombre obtenue par la sous-gravure; par alignement sur l'unique bord médian de la couche de laque restante 5, on obtient une zone non recouverte, de largeur constante submicronique, par suite de l'effet d'ombre, qui constitue donc une deuxième fenêtre submicronique f, intermédiaire car elle disparaîtra après usage.

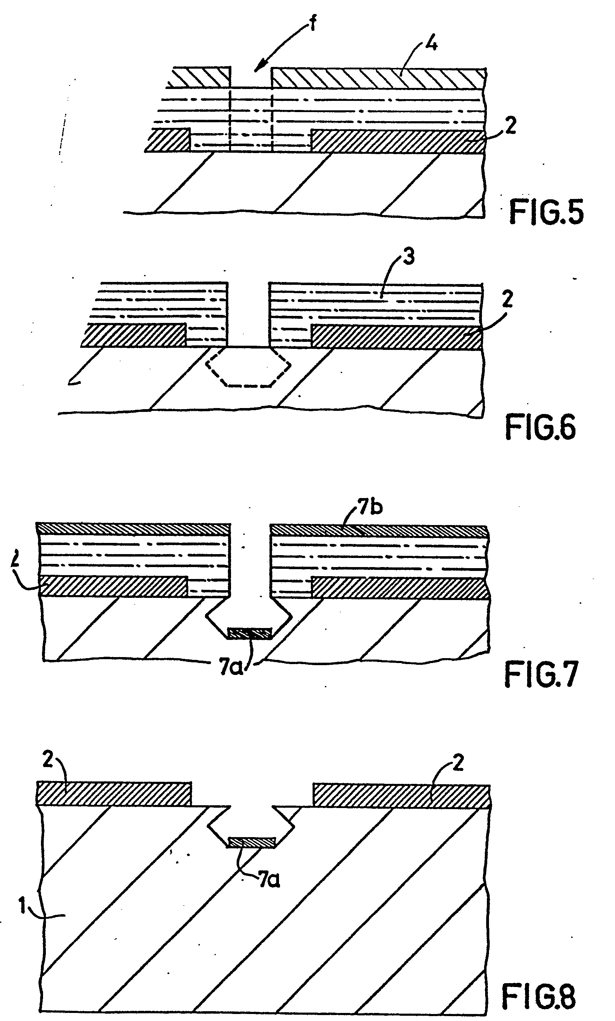

On enlève alors la laque non sensibilisée au moyen d'un solvant approprié. Dans le cas d'une laque fine positive telle que la laque Shipley AZ 1350, l'acétone convient parfaitement à cet effet. Avec le départ de cette couche de laque, la couche de matériau inerte 6 qui s'est déposée sur cette couche de laque 5 est également retirée (procédé dit de "lift-off", en anglo-saxon, ou de "pelage" selon le terme spécialisé). On obtient alors, conformément à la figure 5, deux fenêtres emboîtées l'une dans l'autre, la première micronique F et la seconde submicronique f.

On illumine alors à nouveau l'ensemble, par exemple au moyen d'un rayonnement X ou UV profond dans le cas d'utilisation d'une laque épaisse PMMA, et l'on procède alors à l'attaque de la portion de laque illuminée au moyen de, par exemple, l'iso-butylméthyl-cétone, les solutions de développement appropriées variant en fonction de la laque utilisée, mais étant généralement indiquées et fournies par le fabricant. La fenêtre intermédiaire submicronique f peut être alors retirée, au moyen de par exemple un plasma tétrafluorure de carbone-oxygène (CF$_4$/O$_2$), conformément à la figure 6.

La couche semiconductrice est ensuite gravée dans la zone non recouverte par la laque; dans le cas du choix d'arséniure de gallium en tant que matériau semiconducteur, une solution de gravure appropriée est par exemple l'acide citrique dilué, et l'on obtient ainsi une cavité dont la forme dépend principalement de la solution d'attaque mais peut également dépendre d'une pluralité d'autres paramètres tels que l'orientation cristallographique etc.... Il est alors possible de déposer une autre couche métallique 7 en un métal qui va former un contact redresseur avec le matériau semiconducteur, par exemple de l'aluminium qui va tapisser le fond de cette cavité (7a), mais qui, par l'effet d'ombre, entretenu par les parois verticales de la couche de laque 3, va être parfaitement délimité et autoaligné par rapport auxdites parois, conformément à la figure 7.

Le produit final, après enlèvement de la laque restante non illuminée, par exemple au moyen de trichloréthylène, et des portions de la couche métallique supérieure (7b) par pelage, est représenté à la figure 8.

Ce produit final, ici un transistor à effet de champ à grille Schottky, se distingue précisément d'autres transistors obtenus par d'autres procédés antérieurs en ce que la cavité creusée dans le matériau semiconducteur n'est pas définie ni limitée par les couches métalliques (2) formant électrodes de source et de drain.

Il est bien évident pour l'homme de l'art que de nombreuses variantes peuvent être imaginées sans pour cela sortir du cadre de la présente invention tel que défini par les revendications ci-après annexées. Ainsi, le contact redresseur formé par la dernière couche métallique 7 peut être obtenu par l'aluminium mais également d'autres métaux tels que par exemple la succession de couches métalliques titane/platinet/or et alia. De même, le choix des laques peut varier à l'infini, mais le couple choisi n'est pas entièrement libre en ce que les solutions chimiques d'enlèvement de ces laques (illuminée ou non illuminée) doivent être différentes pour que lors de la première immersion destinée à enlever une portion de la couche supérieure (5) la couche inférieure (3) ne subisse aucune altération et en ce que le rayonnement sensibilisant (UV) de la couche de laque supérieure (5) soit de plus grande longueur d'onde que celui (X, UV profond) de la couche de laque inférieure (3), de manière à pouvoir être arrêté par la troisième couche (4) disposée entre ces deux couches de laque.

**Revendications**

1. Procédé de réalisation d'une ouverture de faible dimension, dans un substrat, comportant la succession d'étapes suivantes:

a) dépôt sur le substrat d'une couche de laque sensible à des rayonnements de faible longueur d'onde, d'une couche de matériau opaque à ces rayonnements, et d'une seconde couche de laque sensible à des rayonnements de plus forte longueur d'onde;

b) exposition au rayonnement de plus forte longueur d'onde à travers un masque qui découvre une zone entière du substrat ainsi recouvert;

c) dissolution de la portion de ladite seconde couche de laque illuminée;

d) attaque de la couche de matériau opaque non recouverte de laque, et poursuite de l'attaque jusqu'à l'obtention d'une sous-gravure sur une distance typiquement inférieure au micromètre;

e) dépôt d'une nouvelle couche de matériau opaque, par alignement sur le bord découvert de ladite seconde couche de laque;

f) dissolution de la seconde couche de laque non illuminée;

g) exposition au rayonnement de faible longueur d'onde;

h) dissolution de la première couche de laque illuminée;

i) gravure du substrat, sous la forme d'une ouverture de faible dimension;

j) dissolution de la première couche de laque non illuminée.

2. Procédé de fabrication de transistors à effet de champ, à grille submicronique alignée, à partir d'un matériau semiconducteur (1) recouvert d'une première couche métallique (2) formant un contact ohmique avec ledit matériau semiconducteur, sous la forme de deux zones formant les électrodes de source et de drain, séparées par une fenêtre micronique, comportant les étapes suivantes:

a) l'on dépose une seconde couche (3) en une laque sensible aux rayonnements de faible longueur d'onde, tels que les rayons X ou les UV profonds, une troisième couche (4) en un matériau opaque à ces rayonnements et une quatrième couche (5) en une laque sensible aux rayonnements de plus grande longueur d'onde tels que les ultraviolets;

b) l'on expose ladite quatrième couche (5) à un rayonnement sensibilisant d'ultraviolets, à travers un masque qui découvre en son milieu ledit transistor à effet de champ selon la ligne médiane principale de ladite fenêtre micronique;

c) l'on dissout la laque sensibilisée avec une solution appropriée;

d) l'on effectue une gravure de ladite troisième couche (4) non recouverte et une sous-gravure sur une distance typiquement inférieure au micromètre;

e) l'on dépose une nouvelle couche (6) constituée du même matériau que celui de ladite troisième couche (4), par alignement sur le bord médian de ladite quatrième couche de laque;

f) l'on enlève la laque non sensibilisée avec une solution appropriée;

g) l'on expose la seconde couche (3) en laque à un rayonnement sensibilisant de faible longueur d'onde tel que des rayons X ou des UV profonds;

h) l'on enlève la laque sensibilisée avec une autre solution appropriée;

i) l'on grave le matériau semiconducteur (1) sous la forme d'une cavité;

j) l'on dépose une douche métallique (7), en un métal formant contact redresseur avec ledit matériau semiconducteur, de manière à réaliser, dans ladite cavité, l'électrode de grille (7a), par autoalignement sur les deux bords, voisins de ladite médiane et espacés d'une distance typiquement inférieure au micromètre;

k) l'on enlève la laque non illuminée restante.

3. Procédé de fabrication de transistors à effet de champ, à grille submicronique alignée, selon la revendication 2, caractérisé en ce que ledit matériau semiconducteur (1) est de l'arséniure de gallium.

4. Procédé de fabrication de transistors à effet de champ, à grille submicronique alignée, selon la revendication 2 ou 3, caractérisé en ce que la première couche métallique (2) est en un alliage or-germanium, éventuellement recouvert de nickel, et en ce que la dernière couche métallique (7) est en aluminium.

5. Procédé de fabrication de transistors à effet de champ, à grille submicronique alignée, selon l'une des revendications 2 à 4, caractérisé en ce que les laques sont choisies de telle sorte que leurs solutions chimiques d'enlèvement soient différentes et en ce que le rayonnement sensibilisant de la couche de laque supérieure (5) soit de plus grande longueur d'onde que celui de la couche de laque inférieure (3) de manière à pouvoir être arrêté par la troisième couche (4), disposée entre elles.

6. Transistors à effet de champ, à grille submicronique alignée, obtenus par la mise en oeuvre du procédé selon l'une des revendications 2 à 5.

## Patentansprüche

1. Verfahren zum Anbringen einer kleinen Öffnung in einem Substrat, wobei dieses Verfahren die untenstehenden Schritte aufweist:

a) das Niederschlagen einer Lackschicht, die empfindlich ist für Strahlung mit geringer Wellenlänge, einer Schicht aus einem Material, das für diese Strahlung undurchlässig ist und einer zweiten Lackschicht aus einem Material, das für diese Strahlung durchlässig ist für Strahlung mit einer grösseren Wellenlänge auf dem Substrat;

b) das Aussetzen an einer Strahlung mit einer grösseren Wellenlänge über eine Maske, die eine ganze Zone des auf diese Weise bedeckten Substrates freilässt;

c) das Lösen des Teils der genannten zweiten Schicht belichteten Lackes;

d) das Angreifen der Schicht aus durchlässigem Material, die nicht mit Lack bedeckt ist, wobei dieser Schritt fortgesetzt wird, bis über einen Abstand von weniger als 1 µm eine Unterätzung erhalten worden ist;

e) das Niederschlagen einer neuen Schicht aus durchlässigem Material durch Ausrichtung längs des unbedeckten Randes der genannten zweiten Lackschicht;

f) das Lösen der zweiten Schicht nichtbelichteten Lackes;

g) das Aussetzten an einer Strahlung mit geringer Wellenlänge;

h) das Lösen der ersten Schicht belichteten Lackes;

i) das Ätzen des Substrates zum Erhalten einer kleinen Öffnung;

j) das Lösen der ersten Schicht nichtbelichteten Lackes.

2. Verfahren zum Herstellen von Feldeffekttransistoren mit einer ausgerichteten Gate-Elektrode in dem Submikronbereich aus einem Halbleitermaterial (1), das mit einer ersten metallischen Schicht (2) bedeckt ist, die mit dem genannten Halbleitermaterial einen ohmschen Kontakt bildet in Form zweier Zonen, welche die Source- und Drain-Elektroden bilden, die durch ein Fenster in dem Mikronbereich voneinander getrennt sind, wobei die folgenden Schritte durchgeführt werden:

a) es wird eine zweite Schicht (3) aus einem Lack angebracht, der für Strahlung mit geringer Wellenlänge, wie Röntgen- oder tiefe UV-Strahlung empfindlich ist, weiterhin eine dritte Schicht (4) aus einem für diese Strahlung undurchlässigen Material und eine vierte Schicht (5) aus einem Lack, der für Strahlung grösserer Wellenlänge empfindlich ist, wie für UV-Strahlung;

b) die genannte vierte Schicht (5) wird einer sensibilisierenden UV-Strahlung ausgesetzt und zwar über eine Maske, die in der Mitte den genannten Feldeffekttransistor längs der Hauptmittellinie des genannten Fensters in dem Mikronbereich freilässt;

c) der sensibilisierte Lack wird mit einem geeigneten Lösungsmittel gelöst;

d) es wird ein Ätzvorgang der genannten dritten unbedeckten Schicht (4) und ein Unterätzvorgang über einen Abstand von weniger als 1 µm durchgeführt;

e) es wird eine neue Schicht (6) aus demselben Material wie dem der genannten dritten Schicht (4) durch Ausrichtung längs des zentralen Randes der genannten vierten Lackschicht niedergeschlagen;

f) der nicht-sensibilisierte Lack wird durch eine geeignete Lösung entfernt;

g) die zweite Lackschicht (3) wird einer sensibilisierenden Strahlung mit geringer Wellenlänge, wie Röntgenstrahlung oder teifer UV-Strahlung ausgesetzt;

h) der sensibilisierte Lack wird durch eine andere geeignete Lösung entfernt;

i) das Halbleitermaterial (1) wird geätzt um einen Hohlraum zu erhalten;

j) es wird eine metallische Schicht (7) aus einem Metall, das mit dem genannten Halbleitermaterial einen Gleichrichtkontakt bildet, niedergeschlagen, so dass in dem genannten Hohlraum die Gate-Elektrode (7a) durch Selbstausrichtung längs der zwei Nachbarränder der genannten Mittellinie gebildet wird, wobei diese Ränder in einem Abstand von weniger als 1 µm liegen;

k) der restliche nicht-belichtete Lack wird entfernt;

3. Verfahren zum Herstellen von Feldeffekttransistoren mit einer ausgerichteten Gate-Elektrode in dem Submikronbereich nach Anspruch 2, dadruch gekennzeichnet, dass das genannte Halbleitermaterial (1) Galliumarsenid ist.

4. Verfahren zum herstellen von Feldeffekttransistoren mit einer ausgerichteten Gate-Elektrode in dem Submikronbereich nach Anspruch 2 oder 3, dadurch gekennzeichnet, dass die erste metallische Schicht (2) aus einer Gold-Germaniumlegierung besteht, die mit Nickel bedeckt sein kann und dass die letzte metallische Schicht (7) aus Aluminium besteht.

5. Verfahren zum Herstellen von Feldeffekttransistoren mit einer ausgerichteten Gate-Elektrode in dem Submikronbereich nach einem der Ansprüche 2 bis 4, dadurch gekennzeichnet, dass die Lacke derart gewählt sind, dass ihre chemische Entfernungslösungen unterschiedlich sind und dass die sensibilisierende Strahlung der oberen Lackschicht (5) eine grössere Wellenlange aufweist als die der unteren Lackschicht (3), so dass diese durch die dritte Schicht (4), die auf denselben niedergeschlagen ist, zurückgehalten werden kann.

6. Feldeffekttansistoren mit einer ausgerichteten Gate-Elektrode in dem Submikronbereich, erhalten mittels des Verfahrens nach einem der Ansprüche 2 bis 5.

## Claims

1. A method of providing a small-sized opening in a substrate, comprising the following succession of steps:

a) depositing on the substrate a layer of a lacquer sensitive to radiations of small wave-length, a layer of a material opaque to these radiations and a second layer of a lacquer sensitive to radiations of larger wave-lengths;

b) exposing to radiation of a larger wave-length through a mask which exposes a whole zone of the substrate thus coated;

c) dissolving the part of the said second layer of exposed lacquer;

d) attacking the layer of opaque material not coated with lacquer, which attacking is continued until an under-etching is obtained over a distance typically less than a micrometre;

e) depositing a new layer of opaque material by alignment along the exposed edge of the said second lacquer layer;

f) dissolving the second layer of non-exposed lacquer;

g) exposing to radiation of small wave-length;

h) dissolving the first layer of exposed lacquer;

i) etching the substrate so as to form a small-sized opening;

j) dissolving the first layer of non-exposed lacquer.

2. A method of manufacturing field effect transistors having acaligned gate in the submicron range from a semi-conductor material (1) covered with a first metallic layer (2) forming an ohmic contact with the said semiconductor material in the form of two zones constituting the source and drain electrodes separated by a window in the micron range, comprising the following steps.

a) a second layer (3) of a lacquer sensitive to the radiations of small-wavelength, such as X- or deep UV radiations, a third layer (4) of a material opaque to these radiations and a fourth layer (5) of a lacquer sensitive to the radiations of larger wave-length, such as ultraviolet radiations, are deposited;

b) the said fourth layer (5) is exposed to a sensitizing ultraviolet radiation through a mask which exposes at its centre the said field effect transistor along the main centre line of the said window in the micron range;

c) the sensitized lacquer is dissolved with a suitable solution;

d) an etching of the said third uncovered layer (4) and an under-etching over a distance typically less than a micrometre are carried out;

e) a new layer (6) constituted by the same material as that of the said third layer (4) is deposited by alignment along the central edge of the said fourth lacquer layer;

f) the non-sensitized lacquer is removed by a suitable solution;

g) the second layer (3) of lacquer is exposed to a sensitizing radiation of small wave-length, such as X-rays or deep UV radiations;

h) the sensitized lacquer is removed by another suitable solution;

i) the semiconductor material (1) is etched so as to form a cavity;

j) a metallic layer (7) of a metal forming a rectifying contact with the said semiconductor material is deposited so that in the said cavity the gate electrode (7a) is formed by self-alignment along the two adjacent edges of the said centre line which are spaced at a relative distance typically less than a micrometre;

k) the remaining non-exposed lacquer is removed.

3. A method of manufacturing field effect transistors having an aligned gate in the submicron range as claimed in Claim 2, characterised in that the said semiconductor material (1) is gallium arsenide.

4. A method of manufacturing field effect transistors having an aligned gate in the submicron range as claimed in Claim 2 or 3, characterised in that the first metallic layer (2) consists of an alloy of gold-germanium, which may be covered with nickel, and in that the last metallic layer (7) consists of aluminium.

5. A method of manufacturing field effect transistors having an aligned gate in the submicron range as claimed in Claims 2 to 4, characterised in that the lacquers are chosen so that their chemical removing solutions are different and in that the sensitizing radiation of the upper lacquer layer (5) has a larger wave-length than that of the lower lacquer layer (3) so that it can be held back by the third layer (4) disposed between them.

6. Field effect transistors having an aligned gate in the submicron range obtained by means of the method as claimed in any one of Claims 2 to 5.

7

0 104 686

FIG.1

FIG.2

FIG.3

FIG.4

1

FIG.5

FIG.6

FIG.7

FIG.8